# EUROPÄISCHE PATENTANMELDUNG

(11) **EP 2 448 011 A2**
(43) Veröffentlichungstag der Anmeldung: **02.05.2012**
(21) Anmeldenummer: 11007701.3
(22) Anmeldetag: 22.09.2011
(51) Int. Cl.: H01L 31/048, H01L 31/0203, B32B 17/06, B32B 17/10

(54) **Verfahren zum Herstellen einer Randversiegelung von Photovoltaik-Modulen sowie Verwendung eines Strangkörpers hierfür**

(30) Priorität: 30.10.2010 DE 102010050187
(71) Anmelder: Robert Bürkle GmbH, 72250 Freudenstadt (DE)
(72) Erfinder: Damm, Norbert, 76689 Karlsdorf-Neuthard (DE)
(74) Vertreter: Lemcke, Brommer & Partner

(57) **Zusammenfassung**

Die Erfindung betrifft ein Verfahren zum Herstellen einer Randversiegelung von Photovoltaik-Modulen, die im Wesentlichen aus einem Deckglas, einem Rückseitenglas, einer Solarzellenschicht und einer wärmeaktivierbaren Kleberschicht zum Ausbilden eines laminierten Schichtverbundes zusammengesetzt werden. Zur Herstellung der Randversiegelung dient ein Strangkörper mit einem mechanisch wenig nachgiebigen Kern und einer wärmeaktivierbar adhäsiven Randschicht oder Mantelschicht. Wichtig ist, dass die Nachgiebigkeit des Kerns des Strangkörpers beim Erweichen der wärmeaktivierbaren Kleberschicht während des Laminierens des Photovoltaik-Moduls geringer ist als die Nachgiebigkeit der erweichenden Kleberschicht.

## Beschreibung

Die Erfindung betrifft ein Verfahren zum Herstellen einer Randversiegelung von Photovoltaik-Modulen nach dem Oberbegriff des Anspruchs 1 sowie die Verwendung eines Strangkörpers zum Herstellen einer solchen Randversiegelung.

Ein Verfahren der vorliegenden Art wird bei Photovoltaik-Modulen angewandt, die insbesondere ein Deckglas, ein Rückseitenglas sowie eine zwischen diesen Komponenten angeordnete Solarzellenschicht umfassen. Die Solarzellenschicht kann eine Dünnschicht-Solarzellenschicht oder eine Schicht aus einer Mehrzahl von nebeneinander angeordneten und miteinander verschalteten multi-, poly- oder monokristallinen Solarzellen sein. Zwischen dem Deckglas und dem Rückseitenglas ist außerdem eine wärmeaktivierbare Kleberschicht vorgesehen, die beispielsweise in Form zweier oberhalb und unterhalb der Solarzellenschicht angeordneter Kleberfolien aus einem transparenten thermoreaktiven Adhäsivstoff wie Ethylenvenylacetat (EVA) oder einem thermoplastischen Werkstoff besteht. Aufgrund dieser Kleberschicht kann durch Laminieren unter Druck- und Wärmeeinwirkung ein Schichtverbund, bestehend im Wesentlichen aus dem Deckglas, dem Rückseitenglas und der Solarzellenschicht hergestellt werden, wobei die Solarzellenschicht dann in einer klaren, dreidimensional vernetzten oder ausgehärteten, nicht mehr aufschmelzbaren Kunststoffschicht eingebettet ist. Mittels dieser Kunststoffschicht sind das Deckglas und das Rückseitenglas dann fest miteinander verbunden, und die Solarzellen sind mitsamt ihrer Verschaltung dazwischen bzw. darin fixiert.

Für die Dauerhaltbarkeit von Photovoltaik-Modulen ist es von größter Wichtigkeit, die Solarzellenschicht und deren elektrische Kontaktierungselemente dauerhaft feuchtigkeitsdicht und gegen den Zutritt von Luftsauerstoff geschützt einzukapseln. Das Deckglas und das Rückseitenglas eines Photovoltaik-Moduls der vorliegend verwendeten Art bilden eine wetterfeste und dennoch lichtdurchlässige, dauerhaft diffusions- und feuchtigkeitsdichte Abdeckung. Problematisch ist jedoch der umlaufende Rand des Photovoltaik-Moduls, zwischen den beiden Glasplatten. Zwar ist der Zwischenraum zwischen den beiden Glasplatten beim fertigen Photovoltaik-Modul randseitig im allgemeinen durch die auflaminierte Kleberschicht ausgefüllt, so dass die Solarzellenschicht und ihre Kontaktierungselemente auch zum Rand des Photovoltaik-Moduls hin eingekapselt sind, jedoch sind die üblicherweise verwendeten Kleberschichten aus Materialien wie z.B. EVA, PVB und TPU erfahrungsgemäß nicht dauerhaft feuchtigkeitsdicht; darüber hinaus können diese Materialien den Zutritt von Luftsauerstoff zur Solarzellenschicht nicht vollständig und dauerhaft gewährleisten.

Da Solarzellen und ihre Kontaktierungselemente durch Feuchte und Luftsauerstoff geschädigt werden, Photovoltaik-Module jedoch gleichzeitig ganzjährig im Freien eingesetzt werden und über einen langen Zeitraum von mindestens 20 Jahren möglichst ihre volle Leistung abgeben sollen, wird im Stand der Technik zunehmend eine zusätzliche Randversiegelung von Photovoltaik-Modulen mit Deckglas und Rückseitenglas eingesetzt, mit deren Hilfe randseitig umlaufend der Zwischenraum zwischen dem Deckglas und dem Rückseitenglas durch ein Material mit besonders hoher Sperrwirkung gegen unerwünschtes Eindringen von Feuchte und Luftsauerstoff ausgefüllt wird. Um die beabsichtigte Sperrwirkung zu erzielen, muss das zur Randversiegelung eingesetzte Material nicht nur gegenüber Feuchte und Luftsauerstoff undurchlässig sein, sondern es muss außerdem eine sehr gute Adhäsionswirkung an den Glasflächen des Deckglases und des Rückseitenglases vorweisen. Hierzu werden Werkstoffe aus hochelastischen und hochadhäsiven Stoffgemengen verwendet, die vorwiegend aus Anteilen von Polyisobutylen (PIB) sowie Füllstoffen wie z. B. Kohlenstaub, Zeoliten, UV-Stabilisatoren, Weichmachern, Haftvermittlern und weiteren Additiven bestehen.

Um die erforderlichen Adhäsionswirkungen an den Glasflächen erzielen zu können, weisen die bislang zur Randversiegelung von Photovoltaik-Modulen verwendeten Materialien wärmeaktivierbare Eigenschaften auf, so dass die Adhäsionseigenschaften beim Laminieren des Photovoltaik-Moduls aktiviert oder gegebenenfalls verstärkt werden. Die Erweichungstemperaturen der Randversiegelungs-Materialien liegen hierbei bislang allerdings notwendigerweise unterhalb des Erweichungsbereichs der wärmeaktivierbaren Kleberschicht im Inneren des Photovoltaik-Moduls; anders ist die erwünschte hohe Adhäsionswirkung der Randversiegelung nicht zu erreichen.

Untersuchungen der Anmelderin haben nun ergeben, dass diese unterschiedlichen Temperaturbereiche der Erweichung von herkömmlichen Randversiegelungen und üblichen Kleberschichten beim Laminieren von Photovoltaik-Modulen mit Deckglas und Rückseitenglas zu Problemen führen können, insbesondere dann, wenn das Laminieren vorteilhafterweise unter Druck- und Wärmeeinwirkung erfolgt, und zwar vorzugsweise in einer Membranpresse. Denn die elastisch verformbare Membran einer Membranpresse, die unter Nutzung einer Druckdifferenz zwischen einem evakuierten Prozessraum und dem atmosphärischen Umgebungsdruck die zum Laminieren erforderliche Flächenlast auf das Photovoltaik-Modul aufbringt, schmiegt sich beim Laminieren eng an die Kontur des Photovoltaik-Moduls an, insbesondere auch in den Randbereichen der Glasplatten, so dass die obenliegende Glasplatte aufgrund höherer Presskräfte an den Rändern deformiert und verbogen wird. Es entsteht insbesondere eine mittige Aufwölbung der obenliegenden Glasplatte, während gleichzeitig die beiden Glasplatten des Photovoltaik-Moduls an den Rändern mehr zusammengedrückt werden, als es dem Sollmaß des Moduls entspricht.

Diese Aufwölbung der obenliegenden Glasplatte erzeugt eine Druckentlastung im innenliegenden Bereich des Photovoltaik-Moduls, so dass sich dort Prozessgase sammeln und zu größeren, bleibenden und sehr unerwünschten Gasblasen konglomerieren können. Ferner entspannen sich die während des Laminierens auf Unter-Sollmaß zusammengepressten Eck- und Randbereiche des Photovoltaik-Moduls nach Beendigung der Druckeinwirkung, wodurch die obenliegende Glasplatte zumindest teilweise in ihre ebene Ausgangsform zurückkehrt. Wenn dies im noch erwärmten Zustand des frisch laminierten Photovoltaik-Moduls geschieht, erfolgt auch hierdurch eine diesmal randseitige Druckentlastung in der Kleberschicht sowie im Randversiegelungsmaterial, wodurch Prozessgase, die während des Laminierprozesses unter der dort herrschenden Druckbelastung in Lösung gehalten waren, äußerst nachteilige Rand- und Eckblasen bilden können.

Diese nachteiligen Effekte einer Randversiegelung, die dem Druck einer Laminierpresse wegen der schnellen Erweichung sehr viel früher weniger Widerstand entgegenbringt, als die eigentliche Kleberschicht des Photovoltaik-Moduls, welche ihrerseits jedoch wegen der Randversiegelung nicht bis an die Ränder der Glasplatten reichen kann, können unter Laborbedingungen durch einen vor dem Laminieren anzubringenden zusätzlichen Hilfsrahmen zwar beseitigt werden. Diesen zunächst anzubringen und nach dem Laminieren wieder zu entfernen und gegebenenfalls zu reinigen, bedeutet jedoch einen Aufwand, der in einer Serienproduktion zu erheblichen Mehrkosten führt.

Ohne einen solchen Hilfsrahmen gibt es jedoch nur die Möglichkeiten, entweder die obigen Nachteile und Probleme in Kauf zu nehmen, die sich durch die Aufwölbung der beim Laminieren obenliegenden Glasplatte ergeben, oder aber ganz auf eine Randversiegelung zu verzichten. Wenn man für die Herstellung der Photovoltaik-Module -was im Hinblick auf die Herstellungskosten sehr wünschenswert ist -sehr viel dünnere Glasplatten verwendet als bisher, besteht darüber hinaus die Gefahr eines Glasbruchs. Selbst wenn diese dünnen Glasplatten nicht brechen, ergeben sich durch ihre erhöhte Deformierbarkeit weitere Schwierigkeiten: Durch das Zusammenpressen von Deckglas und Rückseitenglas in den Eck- und Randbereichen entsteht auf die zwischenliegenden Solarzellen eine in der Modulebene nach innen wirkende Kraft, die in der erweichten Kleberschicht zu einer seitlichen Bewegung der einzelnen Zellen und zu einem Versatz derselben gegeneinander führt, was im schlimmsten Fall einen Kurzschluss der Solarzellenverschaltung verursachen kann.

Ausgehend von diesem Stand der Technik liegt der vorliegenden Erfindung die Aufgabe zugrunde, ein Verfahren zum Herstellen einer Randversieglung von Photovoltaik-Modulen der vorliegenden Art vorzuschlagen, mit dem die skizzierten Probleme beim Laminieren und insbesondere beim Verwenden von vergleichsweise dünnen Deckgläsern und Rückseitengläsern zumindest weitgehend beseitigt sind, so dass auf eine Randversiegelung zukünftig nicht mehr verzichtet werden muss, auch wenn keine Hilfsrahmen beim Laminieren verwendet werden.

Gelöst ist diese Aufgabe durch ein Verfahren mit den Merkmalen des Anspruchs 1 sowie durch die Verwendung eines Strangkörpers wie in Anspruch 12 definiert.

Bevorzugte Ausgestaltungen des erfindungsgemäßen Verfahrens sind in den Ansprüchen 2 bis 11 niedergelegt.

Die vorliegende Erfindung schlägt demnach die Verwendung eines Strangkörpers als Randversiegelung eines Photovoltaik-Moduls mit Rückseitenglas und Deckglas vor, der einen mechanisch wenig nachgiebigen Kern sowie eine wärmeaktivierbar adhäsive Randschicht oder Mantelschicht umfasst.

Für den Kern des Strangkörpers wird erfindungsgemäß ein Material verwendet, dessen Nachgiebigkeit beim Erweichen der wärmeaktivierbaren Kleberschicht des Photovoltaik-Moduls während des Laminiervorgangs geringer ist als die Nachgiebigkeit der erweichenden Kleberschicht. Diese Nachgiebigkeit kann die (geringe) Elastizität eines wenig nachgiebigen Festkörpers sein, sie kann jedoch auch auf einer Viskosität des Kernmaterials beruhen, die dann erfindungsgemäß beim Laminieren des Photovoltaik-Moduls signifikant höher ist als die Viskosität der wärmeaktivierbaren und beim Laminieren erweichenden Kleberschicht. Letzteres eröffnet die Möglichkeit, als Kern des erfindungsgemäßen Strangkörpers einen Schmelzkleber zu verwenden, der gegenüber der wärmeaktivierbaren Kleberschicht des Moduls langsamer oder erst bei einer höheren Temperatur erweicht.

Die Rand- oder Mantelschicht kann vorzugsweise aus einem Polyisobutyl-Werkstoff oder einem Epoxid-Harz gebildet werden. Alternativ kann der Kern des erfindungsgemäßen Strangkörpers auch aus einem strangpressbaren, wenig nachgiebigen Material, wie einem temperaturstabilen Kunststoff oder einem Metall, insbesondere Kupfer, Aluminium oder Zinn, bestehen.

Die relative Anordnung des erfindungsgemäß wenig nachgiebigen Kerns und der wärmeaktivierbar adhäsiven Rand- oder Mantelschicht des erfindungsgemäßen Strangkörpers gegeneinander kann je nach Einsatzzweck sehr unterschiedlich gewählt werden:
So kann der Kern des erfindungsgemäßen Strangkörpers mit einer diesen einhüllenden Mantelschicht versehen werden, so dass sich ein vorgefertigter Strangkörper ergibt, der beim Herstellen des Photovoltaik-Moduls beispielsweise als Bandmaterial von der Rolle oder durch einen robotergeführten, beheizten Extrusionskopf bereitgestellt werden kann. Er kann dann zur Realisierung des erfindungsgemäßen Verfahrens auf die beim Legen der Modulschichten untenliegende Glasplatte, die Solarzellenschicht und die wärmeaktivierbare Kleberschicht umgebend, aufgelegt werden, wonach dann die beim Laminieren obenliegende Glasplatte aufgelegt wird.

Der Kern des erfindungsgemäßen Strangkörpers kann jedoch auch lediglich in denjenigen Bereichen, in denen er mit den Glasplatten des Photovoltaik-Moduls in Kontakt kommt, mit einer wärmeaktivierbar adhäsiven Randschicht versehen werden. Dies erfolgt zweckmäßigerweise durch Aufbringen der adhäsiven Randschicht direkt auf das Deckglas und/oder auf das Rückseitenglas, während der Kern des Strangkörpers dann zwischen diese beiden Randschichten gelangt, wenn die beim Laminieren obenliegende Glasplatte auf die übrigen Schichten des Moduls aufgelegt wird.

Schließlich ist es im Rahmen der vorliegenden Erfindung auch möglich, den Kern und die Randschicht des erfindungsgemäßen Strangkörpers in der Modulebene gesehen nebeneinander anzuordnen, wobei die Randschicht wahlweise radial außerhalb und/oder radial innerhalb des Kerns zu liegen kommt und den lichten Raum zwischen den beiden Glasplatten des Moduls vollständig ausfüllt.

In allen Fällen hat es sich als zweckmäßig erwiesen, wenn die Dicke des erfindungsgemäß wenig nachgiebigen Kerns des Strangkörpers in etwa dem lichten Raum zwischen den beiden Glasplatten im Soll-Abstand entspricht. Die Querschnittsform des Kerns des Strangkörpers kann hierbei variieren; sie kann rechteckig, rund, oval, V-förmig oder in einer sonstigen Form vorliegen. Die Dicke des gesamten erfindungsgemäßen Strangkörpers, also des aus Kern und Rand- oder Mantelschicht zusammengesetzten Materials, beträgt vorzugsweise etwa das 1,2-fache der Dicke des Kerns als solchem. Dies bedeutet, dass eine Mantelschicht in etwa 10 % der Dicke des Kerns aufweist, oder dass eine radial neben dem Kern angeordnete Randschicht die 1,2-fache Dicke des Kerns aufweist. Hierdurch ist gewährleistet, dass auch bei einem Erweichen der Mantel- oder Randschicht während des Laminierens genügend Material vorhanden ist, um den Kontaktbereich zwischen dem Kern und dem Deckglas und/oder dem Rückseitenglas dauerhaft gas- und feuchtedicht abzudichten.

Gegenüber Randversiegelungen nach dem Stand der Technik bietet der erfindungsgemäße Strangkörper eine signifikant erhöhte zusätzliche mechanische Stabilität auf, wodurch eine Deformation der Eck- und Randbereiche des Photovoltaik-Moduls und eine hierdurch resultierende Aufwölbung des Deckglases und/oder des Rückseitenglases beim Laminieren unter Druck- und Wärmeeinwirkung zuverlässig verhindert bzw. weitgehend unterbunden wird. Es kann nun also ohne zusätzliches Anbringen von Hilfsrahmen eine Randversiegelung in ein Photovoltaik-Modul eingebracht werden, ohne das Risiko eines Qualitätsverlustes durch etwaige Gasblasenbildung in Kauf nehmen zu müssen. Darüber hinaus können nun auch Photovoltaik-Module mit vergleichsweise dünnen Rückseitengläsern und Deckgläsern wirtschaftlich mit einer Randversieglung versehen werden, so dass die Haltbarkeit dieser sehr kostengünstig herstellbaren Photovoltaik-Module deutlich erhöht wird.

Anhand der beiliegenden Zeichnungen werden im Folgenden drei Ausführungsbeispiele zur Anwendung des erfindungsgemäßen Verfahrens näher beschrieben und erläutert. Es zeigen:
- Figur 1: einen schematischen Schnitt durch ein Photovoltaik-Modul in zwei Montagephasen a) und b) nach einem ersten Ausführungsbeispiel;
- Figur 2: einen schematischen Schnitt durch ein Photovoltaik-Modul in zwei Montagephasen a) und b) nach einem zweiten Ausführungsbeispiel;
- Figur 3: eine schematische Schnittdarstellung eines fertig laminierten Photovoltaik-Moduls nach einem dritten Ausführungsbeispiel;
- Figur 4: eine schematische Schnittdarstellung eines fertig laminierten Photovoltaik-Moduls nach einem vierten Ausführungsbeispiel;

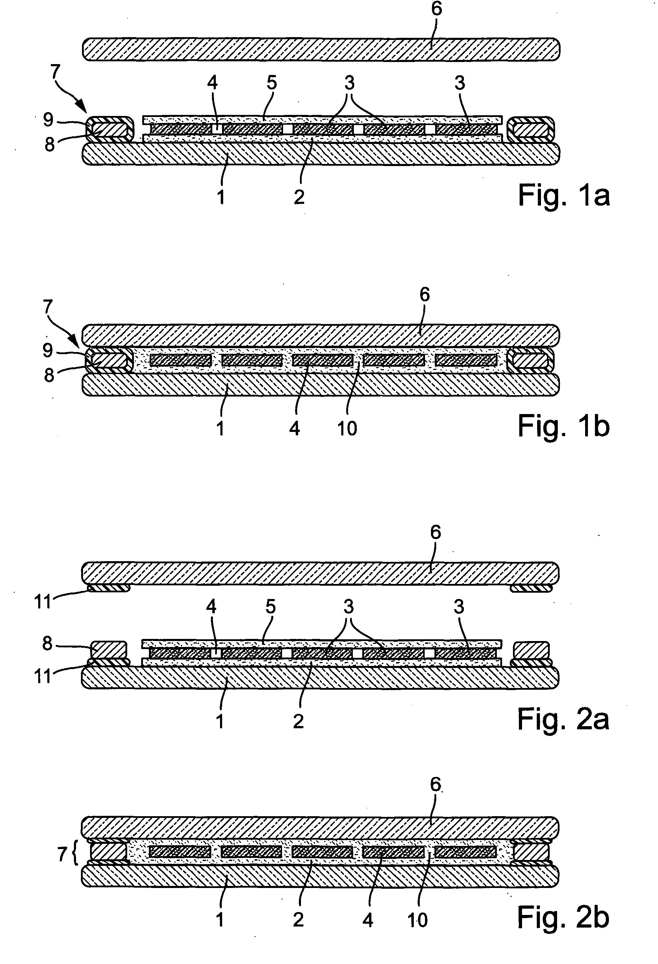

Figur 1 zeigt eine erste (a) und eine zweite (b) Phase des Herstellens eines Photovoltaik-Moduls und im Besonderen des Herstellens einer ersten Ausführung einer erfindungsgemäßen Randversiegelung in schematischen Querschnittsdarstellungen. In Figur 1a wurde ein Deckglas 1 auf einen (nicht dargestellten) Legetisch aufgelegt und darauf eine erste wärmeaktivierbare Kleberschicht 2 in Form einer EVA-Folie aufgelegt. Auf diese erste Kleberschicht 2 wurden sodann eine Anzahl von Solarzellen 3 aufgelegt und mittels (nicht dargestellter) Lötbändchen elektrisch miteinander verschaltet, um eine Solarzellenschicht 4 zu bilden. Auf diese Solarzellenschicht 4 wurde schließlich eine zweite EVA-Folie als weitere Kleberschicht 5 gelegt.

Bevor nun ein Rückseitenglas 6 auf die Solarzellenschicht 4 bzw.. die zweite Kleberschicht 5 aufgelegt wird, wird erfindungsgemäß rund um die Solarzellenschicht 4 und die beiden Kleberschichten 2, 5 umlaufend ein Strangkörper 7 auf den Randbereich des Deckglases 1 aufgelegt, wobei dieser Strangkörper 7 erfindungsgemäß aus einem innenliegenden Kern 8, der mechanisch wenig nachgiebig ist, und einer diesen Kern 8 umgebenden Mantelschicht 9 besteht. Die Mantelschicht besteht aus einem wärmeaktivierbar adhäsiven, unter Wärmeeinwirkung viskosen Material. Der Strangkörper 7 ist etwa 1,2-fach so dick wie der Soll-Abstand zwischen dem Deckglas 1 und dem Rückseitenglas 6 des fertigen Photovoltaik-Moduls.

Figur 1b zeigt das fertig laminierte Photovoltaik-Modul, bestehend aus dem Deckglas 1, der in einer transparenten und vernetzten Kleberschicht 10 eingebetteten Solarzellenschicht 4, dem Rückseitenglas 6 und der aus dem Strangkörper 7 mit Kern 8 und Mantelschicht 9 gebildeten Randversiegelung. Anhand dieser Darstellung wird deutlich, dass der mechanisch wenig nachgiebige Kern 8 des Randversiegelungs-Strangkörpers 7 ein Zusammenpressen der Randbereiche des Photovoltaik-Moduls und damit ein Aufwölben des Rückseitenglases 6 beim Laminiervorgang zuverlässig dadurch verhinderte, dass er wegen seiner mechanischen Unnachgiebigkeit ebensoviel Gegendruck gegen den von oben auf das Modul wirkenden Laminierdruck aufbrachte, wie die zunächst noch nicht erweichten Kleberschichten 2, 5 im Zusammenwirken mit der Solarzellenschicht 4. Dass die Mantelschicht 9 des Strangkörpers 7 bereits vor einem Erweichen der Kleberschichten 2, 5 fließfähig wurde, störte während des Laminierprozesses nicht. Im Gegenteil: So wurden die Kontaktbereiche zwischen dem Kern 8 und den Glasplatten 1, 6 zuverlässig und dauerhaft gegen ein Eindringen von Feuchte und Luftsauerstoff abgedichtet.

Das erfindungsgemäße Verfahren nach dem Ausführungsbeispiel, das in Figur 1 dargestellt ist, wurde in einem Versuch mit Glasplatten durchgeführt, deren Dicke nur etwa 2 mm und damit etwa die Hälfte der bislang üblichen Dicken betrug. Auch die Dicken der EVA-Folien als erste und zweite Kleberschichten 2, 5 war um etwa 30 % gegenüber dem Stand der Technik reduziert, wodurch sich jeweils enorme Einsparpotentiale realisieren lassen. Der Kern 8 des Strangkörpers 7 bestand aus einem Heißkleber, dessen rheologische Eigenschaften so beschaffen waren, dass während der thermischen Prozessphasen des Laminierens eine ständig höhere Viskosität als in den Kleberschichten 2, 5 vorlag. Diese höhere Viskosität war solcherart höher, dass während des Laminierprozesses keine nennenswerte Eck- oder Randverbiegung der Glasplatten 1, 6 hervorgerufen wurde. Die Dickendifferenz zwischen der Dicke des Photovoltaik-Moduls an dessen äußerem Rand zur Dicke des Innenbereichs (Auswölbung des Rückseitenglases 6) lag vielmehr unter 1/10 mm. Die Mantelschicht 9 des Strangkörpers 7 bestand aus Isobutyl.

Die Dicke des Strangkörpers 7 betrug, wie erwähnt, das 1,2-fache der Dicke der Solarzellenschicht 4 mit umgebender Kleberschicht 10 im fertig laminierten Zustand. Ein nennenswerter Austritt von adhäsivem Material aus den Rändern des Photovoltaik-Moduls beim Laminiervorgang oder danach wurde nicht festgestellt. Eine nachteilige Verschmutzung der Laminierpresse bzw. von deren Fördereinrichtungen mit adhäsiven Stoffen konnte also außerdem verhindert werden.

Das in Figur 2 visualisierte Ausführungsbeispiel eines erfindungsgemäßen Verfahrens zum Herstellen einer Randversiegelung von Photovoltaik-Modulen unterscheidet sich von dem in Figur 1 gezeigten nur durch die Ausbildung des Strangkörpers 7: Dieser wird durch Aufbringen zweier Randschichten 11 auf die innenliegenden Ränder des Deckglases 1 und des Rückseitenglases 6 sowie durch separates Auflegen des Kerns 8 auf die auf dem Deckglas 1 befindliche Randschicht 11 hergestellt. Nach dem Auflegen des Rückseitenglases 6 ergibt sich eine dreischichtige Ausbildung der Randversiegelung, bestehend aus dem zwischen den beiden Randschichten 11 eingeschlossenen Kern 8. Nach dem Laminieren (Figur 2b) ist aus diesen drei Schichten der Strangkörper 7 entstanden, der sich in seinen Eigenschaften dann nicht mehr vom Strangkörper 7 des Ausführungsbeispiels aus Figur 1b unterscheidet. Hier ist im übrigen gut erkennbar, dass der erfindungsgemäß wenig nachgiebige Kern 8 des Strangkörpers 7 eine zuverlässige Barriere gegen den Austritt von adhäsivem Material aus den erweichten Kleberschichten 2, 5 bildet.

Nach dem Erkalten und während des Einsatzes des Photovoltaik-Moduls bildet der Strangkörper 7 bestimmungsgemäß die Barriere gegen Eindringen von Feuchtigkeit und Luftsauerstoff aus der Umgebung in das Innere des Photovoltaik-Moduls. Die beiden Randschichten 11 stellen hierbei eine feste und dauerhafte Verbindung zwischen dem Kern 8 und dem Deckglas 1 sowie dem Rückseitenglas 6 sicher.

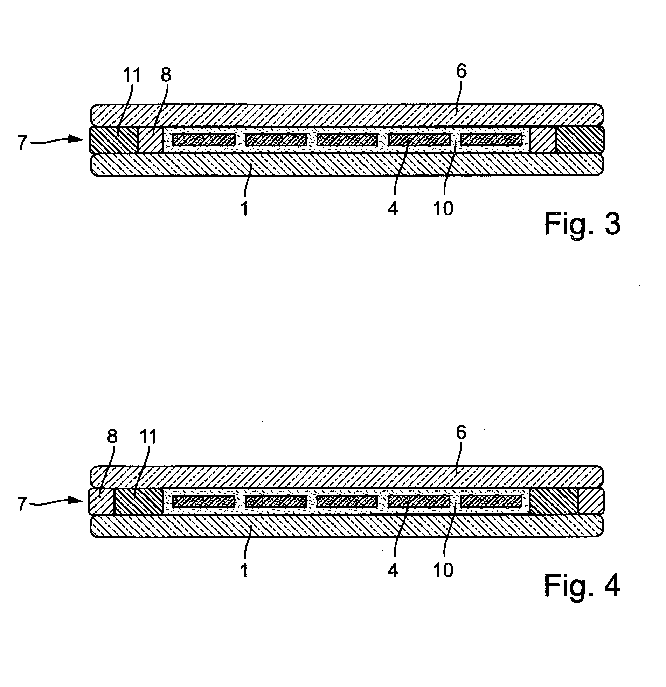

Die Figuren 3 und 4 zeigen jeweils eine schematische Schnittdarstellung eines fertig laminierten Photovoltaik-Moduls, wie dies bereits in den Figuren 1b und 2b der Fall ist. Die in den Figuren 3 und 4 gezeigten Photovoltaik-Module unterscheiden sich von den vorhergehenden durch die Ausbildung des Strangkörpers 7:

Dieser besteht hier jeweils aus einem im Randbereich des Photovoltaik-Moduls umlaufenden Kern 8 und einer in der Modulebene liegenden, radial außen (Figur 3) bzw. radial innen (Figur 4) an den Kern 8 angrenzenden, diesem benachbarten Randschicht 11 aus wärmeaktivierbar adhäsivem Material. Der Kern 8 ist wiederum so dick ausgebildet, wie die Kleberschicht 10 mit der darin eingebetteten Solarzellenschicht 4, während die Randschicht 11 in ihrem Ausgangszustand etwa 20 % dicker ausgebildet war. Durch das Aufschmelzen beim Laminieren hatte sich diese Dicke reduziert, wodurch sichergestellt wurde, dass sich die Randschicht 11 beidseits mit dem Deckglas 1 und dem Rückseitenglas 6 dauerhaft und gas- sowie feuchtedicht verband.

## Patentansprüche

1. Verfahren zum Herstellen einer Randversiegelung von Photovoltaik-Modulen, die im Wesentlichen aus einem Deckglas (1), einem Rückseitenglas (6), einer zwischen diesen Glasplatten (1, 6) angeordneten Solarzellenschicht (4) und mindestens einer zwischen den Glasplatten (1, 6) befindlichen, wärmeaktivierbaren Kleberschicht (2, 5) zum Ausbilden eines laminierten Schichtverbundes (1, 10, 4, 6) zusammengesetzt werden,
**dadurch gekennzeichnet,**
**dass** zur Randversiegelung eines solchen Photovoltaik-Moduls zwischen das Deckglas (1) und das Rückseitenglas (6) randseitig umlaufend ein Strangkörper (7) mit einem Kern (8) und einer wärmeaktivierbar adhäsiven Randschicht (11) oder Mantelschicht (9) eingelegt wird, wobei für den Kern (8) des Strangkörpers (7) ein Material verwendet wird, dessen Nachgiebigkeit beim Erweichen der wärmeaktivierbaren Kleberschicht (2, 5) während des Laminierens des Photovoltaik-Moduls geringer ist als die Nachgiebigkeit der hierbei erweichenden Kleberschicht (2, 5).

2. Verfahren nach Anspruch 1,
**dadurch gekennzeichnet,**
**dass** für den Kern (8) des Strangkörpers (7) ein Material verwendet wird, dessen Viskosität beim Laminieren des Photovoltaik-Moduls höher ist als die Viskosität der wärmeaktivierbaren Kleberschicht (2, 5).

3. Verfahren nach Anspruch 1,
**dadurch gekennzeichnet,**
**dass** für den Kern (8) des Strangkörpers (7) ein strangpressbares Material, wie ein temperaturstabiler Kunststoff oder ein Metall, insbesondere Kupfer, Aluminium oder Zinn, verwendet wird.

4. Verfahren nach mindestens einem der Ansprüche 1 bis 3,
**dadurch gekennzeichnet,**
**dass** ein Strangkörper (7) mit einem Kern (8) und einer diesen einhüllenden Mantelschicht (9) verwendet und dieser Strangkörper (7) zwischen das Rückseitenglas (6) und das Deckglas (1) eingelegt wird, bevor das Photovoltaik-Modul laminiert wird.

5. Verfahren nach mindestens einem der Ansprüche 1 bis 3,
**dadurch gekennzeichnet,**
**dass** der Kern (8) und eine gegenüber dem Kern (8) dicker ausgebildete Randschicht (11) des Strangkörpers (7), in der Ebene des Photovoltaik-Moduls gesehen nebeneinander angeordnet zwischen das Rückseitenglas (6) und das Deckglas (1) eingelegt werden, bevor das Photovoltaik-Modul laminiert wird.

6. Verfahren nach mindestens einem der Ansprüche 1 bis 3;
**dadurch gekennzeichnet,**
**dass** der Strangkörper (7) hergestellt wird, indem auf das Rückseitenglas (6) und das Deckglas (1) eine wärmeaktivierbar adhäsive Randschicht (11) aufgebracht und der Kern (8) zwischen diese beiden Randschichten (11) eingelegt wird, bevor das Photovoltaik-Modul laminiert wird.

7. Verfahren nach mindestens einem der Ansprüche 1 bis 6,
**dadurch gekennzeichnet,**
**dass** ein Strangkörper (7) mit einem Kern (8) verwendet wird, dessen Dicke in etwa der Soll-Dicke des fertigen Photovoltaik-Moduls abzüglich der Dicken des Rückseitenglases (6) und des Deckglases (1) entspricht.

8. Verfahren nach Anspruch 7,
**dadurch gekennzeichnet,**
**dass** ein Strangkörper (7) mit einer Gesamtdicke verwendet wird, die in etwa dem 1,2-fachen der Dicke des Kerns (8) entspricht.

9. Verfahren nach mindestens einem der Ansprüche 1 bis 8,
**dadurch gekennzeichnet,**
**dass** ein Strangkörper (7) verwendet wird, dessen Randschicht (11) oder Mantelschicht (9) aus einem Polyisobutyl-Werkstoff oder einem Epoxid-Harz gebildet wird.

10. Verfahren nach Anspruch 9.
**dadurch gekennzeichnet,**
**dass** ein Strangkörper (7) verwendet wird, dessen Kern (8) im Wesentlichen aus einem Schmelzkleber besteht.

11. Verfahren nach mindestens einem der Ansprüche 1 bis 9,
**dadurch gekennzeichnet,**
**dass** ein Strangkörper (7) verwendet wird, der aus einem im fertig laminierten Zustand transparenten Material besteht.

12. Verwendung eines Strangkörpers (7) mit einem mechanisch wenig nachgiebigen Kern (8) und einer wärmeaktivierbar adhäsiven Randschicht (11) und/oder Mantelschicht (9) zur Randversiegelung eines Photovoltaik-Moduls mit Rückseitenglas (6) und Deckglas (1).
